# EUROPEAN PATENT APPLICATION

(11) **EP 2 067 877 A1**
(43) Date of publication of application: **10.06.2009**
(21) Application number: 07121435.7
(22) Date of filing: 23.11.2007
(51) Int. Cl.: C23C 16/455, C03C 17/00

(54) **Coating device and method of producing an electrode assembly**

(71) Applicant: Applied Materials, Inc., Santa Clara, CA 95054 (US)
(72) Inventor: Wieder, Stephan, 60385, Frankfurt (DE)
(74) Representative: Lermer, Christoph

(57) **Abstract**

An electrode assembly 12 for a PECVD (Plasma Enhanced Chemical Vapour Deposition) coating installation comprises a base plate 13, a separation plate 14 and an electrode plate 15. The electrode plate 15 includes frame members 16. Fixing elements 17 are provided for fixing the electrode plate 15 to the base plate 13. Furthermore, the electrode assembly 12 comprises a plurality of gas distribution elements 2 that distribute process gas to provide a homogeneous plasma P above the surface of a substrate 19. In this way a uniform coating can be deposited on the substrate 19. The gas distribution elements 2 are modules having a similar or identical construction. Therefore, they may be manufactured in particular machines and handled easily before being integrated in an electrode assembly according to the present invention. Another advantage of the gas distribution system 1 is that due to the composition of the elements 2 (that may be formed like small cassettes or tiles) the construction of the electrode assembly according to the present invention is more stable than conventional electrode assemblies.

## Description

### TECHNICAL FIELD

The present invention relates to a coating installation, particularly a PECVD (Plasma Enhanced Chemical Vapor Deposition) coating installation, comprising: at least a process chamber for processing a substrate in said process chamber; and at least an electrode assembly arranged within said process chamber for generating and maintaining a plasma in said process chamber, wherein said electrode assembly comprises an arrangement of outlet openings for feeding process gas into said process chamber. Furthermore, the present invention relates to a method of producing an electrode assembly for a PECVD coating installation.

### PRIOR ART

In a number of technical applications thin layer coatings have to be deposited on a substrate. One of the processes used for depositing thin layers, for example in the production of solar cells, is a PECVD (Plasma Enhanced Chemical Vapor Deposition) process. In a PECVD process a gaseous phase of coating products is generated by means of a plasma. The gaseous reactants containing the layer-forming pre-products are supplied to the process chamber via supply openings.

In order to deposit a homogenous and uniform coating on the substrate a particular gas flow distribution through the outlet openings must be provided, e.g. a homogenous or a uniform gas flow through all or a part of the outlet openings. The gas flow through different outlet openings may also be set to have different values, e.g. different gas flows between outlet openings at the edge of the electrode and in the center of the electrode. For this reason, so-called showerhead electrodes are arranged in the process chamber above the substrate surface to be coated. The showerhead electrodes have a plurality of openings provided within a substantially flat electrode plate. Conventional showerhead electrode plates are known in different shapes, e.g. as circular, square or rectangular showerhead electrode plates. They are provided in different standard sizes for different standard substrate sizes.

In order to obtain a homogenous gas supply above a large substrate surface the gas feed system comprises a gas distribution system with the same conductance values between a central gas feeding point and each of the gas outlet openings. For example, the gas distribution system may comprise a central feed opening and a gas distribution space arranged upstream the openings provided in the electrode plate. The gas pressure at the respective openings should be comparable over the entire electrode plate.

Alternatively, gas conducts may be provided between a central feed opening and the gas outlet openings. Substantially the conducts have the same diameters and the same lengths between the central gas feed inlet and each of the gas outlet openings. Therefore, it is preferred to use two symmetrical branches or H-shaped branchings with a central inlet opening and outlet openings symmetrically arranged at the free ends of the "H".

European patent application EP 07103 473.0 and corresponding US-provisional application 60/892,999 describe new gas feed systems allowing the generation of a homogenous plasma above substrate surfaces.

A problem with conventional showerhead electrodes is that technical problems and thus the production cost increases with their size. Particularly, gas distribution will be more complex with an increasing size, stability problems may arise and the production of large showerhead electrodes will be much more complicated.

### OBJECT OF THE INVENTION

Thus it is an object of the present invention to provide a stable coating installation that may be easily assembled and a method of producing a coating installation cost-efficiently.

### TECHNICAL SOLUTION

This object is achieved by providing a coating installation in accordance with claim 1 and a method of producing a coating installation according to claim 12. Advantageous embodiments result from the dependent claims.

A coating installation, particularly a PECVD coating installation, according to the present invention comprises: at least a process chamber for processing a substrate in said process chamber; and at least an electrode assembly arranged within said process chamber for generating and maintaining a plasma in said process chamber, wherein said electrode assembly comprises an arrangement of outlet openings for feeding process gas into said process chamber. Said electrode assembly comprises a plurality of gas distribution elements, wherein each of said gas distribution elements includes a gas distribution system.

The inventive coating device can be used particularly advantageously in a PECVD coating process, for example in the production of thin-layer silicon solar modules. The silicon layers of solar modules are deposited on a flat glass substrate having quite a large size. A substrate to be coated may be arranged in the coating chamber and be considered as a part of the coating installation.

A plurality of gas distribution elements means that at least two, particularly a larger number of gas distribution elements. The gas distribution elements are part of a coating installation according to the present invention.

The gas distribution elements are made of a conductive material in order to be able to act as the electrode or at least part of the electrode. The electrode may particularly be a cathode. During the operation of the coating device RF frequency voltage, e.g. in the range between 13.6 MHz and 100 MHz, is applied to the electrode and/or to the gas distribution elements.

A homogenous gas distribution is obtained when the flow resistance along each path between a central gas feed opening and the outlet openings of the gas distribution elements is similar or substantially identical. Another possibility to provide a homogenous gas distribution is to provide pressure stages upstream of the outlet openings of the gas distribution elements.

Because usually the gas distribution elements are similar or identical, they may be used for the production of various electrode sizes and aspect ratios of the electrode surface. Standard gas distribution elements (gas distribution modules) may be used for producing various sizes of large-area electrodes.

The gas distribution elements, however, may also have different sizes or construction. For example, in the area near the edge of the electrode, another gas flow may be required than in the central area of the electrode. Therefore, the gas distribution elements may be different in different areas of the electrode. Furthermore, the geometry of the electrode may determine the size of the gas distribution elements.

By using standard elements a plurality of different sizes of rectangular electrodes may be assembled. Electrodes having different sizes may be produced cost-efficiently, providing a homogeneous coating to a substrate in a PECVD process by means of a regular raster of gas outlet openings.

The standard gas distribution elements are easy to manufacture. An electrode assembly according to the invention may be produced and mounted efficiently and time-saving. Furthermore, in case a defect in a gas distribution element occurs, the defective element may be exchanged without having to remove and exchange the complete electrode assembly. Moreover, the stability of the inventive electrode assembly is increased by providing a gas distribution system consisting of small units compared with conventional showerhead electrodes. Furthermore, gas distribution elements of different size and/or construction may be used to provide a predetermined gas flow distribution through the outlet openings and thus a predetermined gas distribution above the surface of the electrode.

In a preferred embodiment said gas distribution elements comprise an inlet opening and at least an outlet opening, and said gas distribution system is arranged between said inlet opening and said at least one outlet opening for homogenously supplying process gas fed into said inlet opening to said at least one outlet opening. Particularly, each of the gas distribution elements comprises a plurality of outlet openings (e.g. 2, 4, 6, 12, 16, a.s.o. openings). The process gases are supplied homogenously into a plasma region of said process chamber via said regular raster of outlet openings.

Said gas distribution element may be formed as a flat panel and/or a cassette and/or a tile-shaped element. The elements are at least partly made of a conductive material. It is preferred that they have a square or rectangular shape with a regular raster of outlet openings on their side facing the substrate.

In the cassette a gas distribution system is provided. The gas distribution system may comprise at least one (central) feed inlet and a system of conducts having branches between the inlet feed opening and the outlet openings. It is preferred that the gas distribution system is constructed to provide the same flow resistance between the feed inlet opening(s) and the outlet openings. The elements may have a plurality of gas conducts and sections thereof branching off in one or more layers. Particularly, the paths between the inlet feed opening and each of the outlet openings may have the same length and diameter profile.

Particularly, the electrode assembly comprises a conduct system having a feed opening and outlet ports to be connected to said inlet openings of said gas distribution elements, and at least a branch-off arranged between said feed opening and said outlet ports of said conduct system. It is preferred that the conduct system that supplies the gas distribution elements with a stream of process gases has a (single) central feed opening.

The conduct system as well as the gas distribution elements may comprise conducts and branch-offs as disclosed in e.g. in EP 0 71 034 73.0 and US 60/892,999 in order to distribute the process gases homogenously and uniformly above the surface of a substrate. The gas distribution elements of the coating installation may be constructed and arranged to provide a predetermined distribution of process gasses above the surface of the electrode within the coating chamber.

The flow resistance of the paths between said feed opening and said outlet openings of said conduct system is substantially the same, i.e. it is constant for all the different ways the gas may take between the feed opening of the conduct system and the outlet openings of the gas distribution elements.

In another preferred embodiment, the conduct system comprises at least one pressure stage arranged in a path between said feed opening and said outlet openings of said conduct system. Particularly, the pressure stage is arranged upstream of the inlet openings of the gas distribution elements.

In another embodiment of the invention the gas distribution element may comprise at least a gas distribution space between said inlet opening and said outlet openings such that there is substantially the same pressure at said outlet openings. For example, each gas distribution element may comprise a (central) feed inlet opening and a regular raster of outlet openings on the side facing the interior of the process chamber. In order to generate a homogeneous plasma for a PECVD plasma coating process a gas distribution space is provided between the inlet feed opening and the outlet openings for distributing the gases homogeneously over the outlet openings. In this embodiment the pressure over the outlet openings and/or the gas flow must be substantially constant.

Particularly, said electrode assembly comprises a frame for supporting said gas distribution elements at said electrode assembly. The only component which has to have a size substantially as big as the complete electrode surface is the frame element which supports the plurality of gas distribution elements. Each of the gas distribution elements may be designed as a kind of a cassette. A number of cassettes are composed and assembled at the frame. The frame may be fixed to an end plate, e.g. a plate which forms a wall of the process chamber.

The frame may comprise gas openings arranged near the edge of the gas distribution system for supplying process gas into the process chamber and/or for removing process gas from the process chamber.

The frame may comprise frame elements forming compartments for inserting one or more gas distribution elements in each of the compartments. The frame elements form a case for receiving the gas distribution elements arranged one besides each other.

In another preferred embodiment, the electrode assembly comprises at least an electrode plate. The electrode plate may be mounted on top of the cassette arrangement. The electrode plate and the cassette arrangement form the electrode of the coating installation. The electrode assembly may be an anode assembly, but usually is a cathode assembly. The electrode plate may have a raster of openings for gas flowing from the outlet openings of the gas distribution elements into the process chamber.

Particularly, the electrode plate may be arranged on top of said gas distribution elements, and said electrode plate faces a plasma generation and maintenance zone.

The method of producing an electrode assembly for a PECVD coating installation according to the present invention comprises the steps of:
a) providing a frame;
b) providing a plurality of gas distribution elements, said gas distribution elements comprising an inlet opening and at least an outlet opening; and
c) arranging and fixing said plurality of gas distribution elements to said frame.

The surface of the elements may have a square or rectangular shape. The gas outlet openings of an element are particularly supplied with process gases through a single inlet opening of the element. The inlet openings of each of the elements of the electrode assembly are supplied by a feed system that comprises e.g. a piping having outlet ports to connect them to the inlet openings of the elements. Producing and mounting the gas distribution elements may be effected efficiently and within a short time.

The method may further comprises the step of providing a gas conduct system for feeding process gas from a feed opening into said inlet openings of said gas distribution elements. When removing gases from the inside of a coating chamber, the outlet opening(s) may remove gas from the process chamber and the inlet opening(s) may be exhaust openings.

The method further comprises the step of providing a plurality of outlet openings in said gas distribution elements.

The structure comprising modular gas distribution elements allows an easy production of the electrode. There is only one large-size component required which extends over the complete electrode surface. This component, e.g. an electrode plate, receives the plurality of elements. Each of the elements is relatively small and has the same construction as the other elements. Therefore, the cassettes may be produced simultaneously using small machines. This reduces the costs of the production of the electrode assembly.

### BRIEF DESCRIPTION OF DRAWINGS

Further characteristics, features and advantages of the present invention will be apparent from the following description of particular embodiments.
- Fig. 1: is a plan view of the gas distribution system according to the present invention;
- Fig. 2: is a plan view of another embodiment of a gas feeding system according to the present invention;
- Fig. 3: is a schematic sectional view an electrode assembly 12 according to the present invention; and
- Fig. 4: is a sectional view of another electrode assembly according to the present invention.

### EMBODIMENT(S) OF THE INVENTION

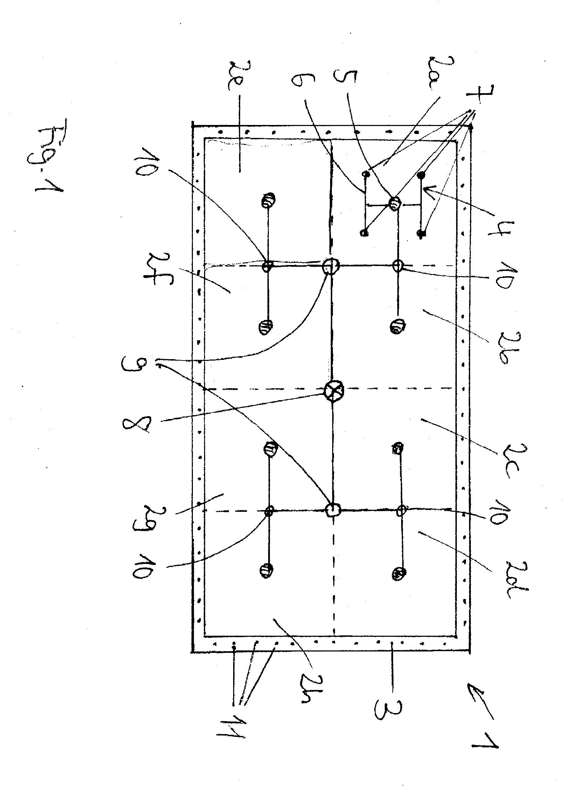

Fig. 1 illustrates a first embodiment of a gas distribution system 1 according to the present invention. The gas distribution system 1 comprises a plurality of gas distribution elements 2a, 2b, 2c, 2d, 2e, 2f, 2g, 2h assembled to a frame 3.

The gas distribution elements 2a, 2b, 2c, 2d, 2e, 2f, 2g, 2h have an identical or similar structure. They have a cassette-like body and a gas distribution system 4 integrated therein. The gas distribution system 4 is only indicated in the first gas distribution element 2a, but the same system is integrated in the other gas distribution elements 2b, 2c, 2d, 2e, 2f, 2g, 2h.

The gas distribution system 4 comprises a central inlet opening 5, a H-shaped conduct system 6 and four outlet openings 7. The flow resistance for gas fed into the inlet opening 5 is the same between the inlet opening 5 and each of the four outlet openings 7. Therefore, a homogenous and uniform gas distribution is provided above a surface of a substrate facing the outlet openings 7. In the present embodiment the gas distribution system and the substrate have a rectangular shape with an aspect ratio of 4:2.

Furthermore, the gas distribution system 1 comprises a conduct system which delivers a mixture of process gasses to the gas distribution elements 2a, 2b, 2c, 2d, 2e, 2f, 2g and 2h. The conduct system comprises a central feed opening 8, first branch-offs 9 and second branch-offs 10. The branch-offs may be located in different layers. Between the central feed opening 8 and the branch-offs 9, 10 conducts are provided having the same flow resistance between the central feed opening 8 and the outlet ports connected to the inlet openings 5 of the gas distribution elements 2a, 2b, 2c, 2d, 2e, 2f, 2g and 2h. In this way, a uniform process gas distribution may be obtained over the entire surface of the gas distribution system 1.

The frame 3 may comprise additional outlet openings 11 for releasing process gasses into the process chamber in order to ensure a uniform gas distribution also in the edge regions of the gas distribution system 1.

According to the invention the gas distribution elements 2a, 2b, 2c, 2d, 2e, 2f, 2g and 2h are modular elements arranged and mounted side by side to form a gas feed system.

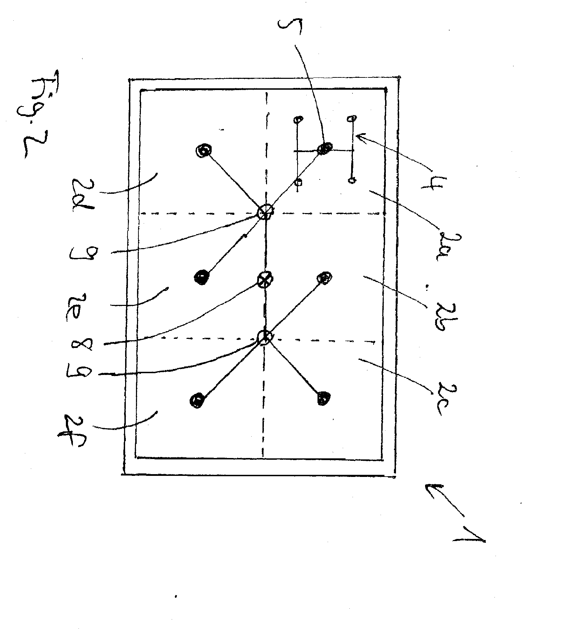

Fig. 2 illustrates a second embodiment of a gas distribution system 1 according to the present invention. The construction is similar to the construction according to the first embodiment. However, the gas distribution system 1 according to the second embodiment comprises six gas distribution elements 2a, 2b, 2c, 2d, 2e, 2f. The gas distribution elements 2a, 2b, 2c, 2d, 2e, 2f are composed to cover an area having an aspect ratio of 3:2. In order to ensure a uniform gas supply to the inlet openings 5 of the elements 2a, 2b, 2c, 2d, 2e and 2f a conduct system is provided which comprises a central feed opening 8 and branch-offs 9 where the gas is discharged into three conducts, each of the three conducts having the same flow resistance between the branch-off 9 and the inlet openings 5 of the gas distribution elements 2a, 2b, 2c, 2d, 2e, 2f. The gas distribution elements 2a, 2b, 2c, 2d, 2e, and 2f are modular elements.

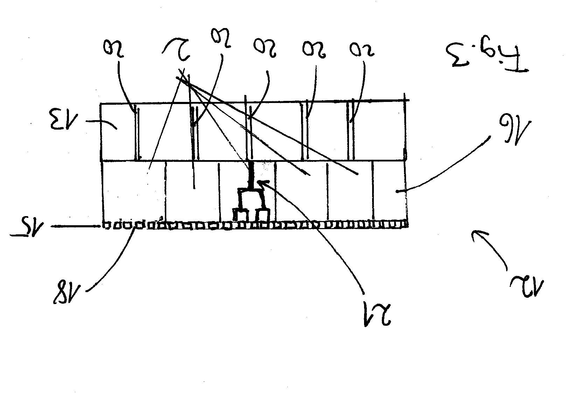

Fig. 3 illustrates a schematic sectional view an electrode assembly 12 according to the present invention.

It comprises a gas outlet plate 15 having a plurality of gas outlet openings 18. A base element 13 comprises a gas supply system having gas supply channels 20 for supplying process gas to gas distribution elements 2 sandwiched between the gas outlet plate 15 and the base element 13. Each of the gas distribution elements 2 comprises a gas distribution system, e.g. a conduit system 21 (only illustrated in one of the gas distribution elements 2) manufactured in the material body of the gas distribution elements 2. Due to the relatively massive construction of the gas distribution elements 2a good heat conduction in the gas distribution portion of the electrode and thus good cooling of the electrode may be effected, compared with conventional showerheads.

Each of the gas distribution elements 2 may comprise a gas distribution system, i.e. a system of channels for distributing the process gas provided through the base element 13 to the outlet openings 18 of the gas outlet plate 15. The gas distribution elements 2 used in electrode assembly 12 may be identical or have different construction, e.g. different sizes. Each of the gas distribution elements 2 or groups of gas distribution elements 2 may be inserted between frame elements 16. The frame elements 16 may form a case having compartments for inserting the gas distribution elements 2.

The electrode arrangement 12 for a PECVD process according to the invention having modular gas distribution elements 2 may be mounted easier than conventional electrodes. Furthermore, the production of the gas distribution elements 2 is less difficult than the production of a gas distribution system provided in a one-piece electrode.

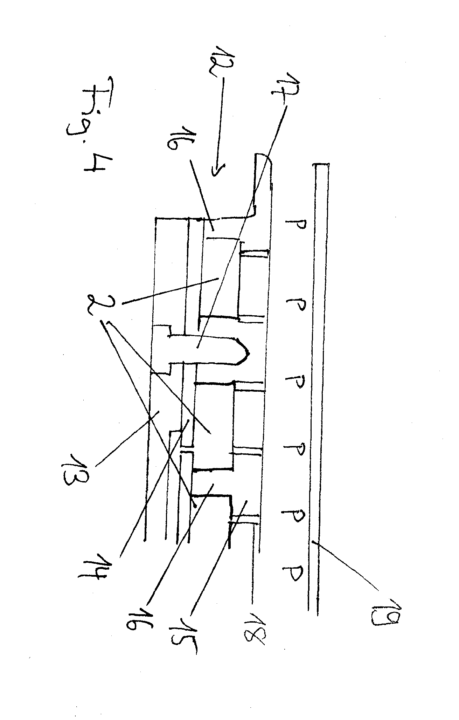

Fig. 4 shows a sectional view of a portion of an electrode assembly 12 according to the present invention.

The electrode assembly 12 comprises a base plate 13, a separation plate 14 and an electrode plate 15. The electrode plate 15 includes frame members 16. Fixing elements 17 are provided for fixing the electrode plate 15 to the base plate 13.

Furthermore, the electrode assembly 12 comprises a plurality of gas distribution elements 2 as described above. The gas distribution elements 2 are modules having a similar or identical construction. The plurality of elements is composed to form a gas distribution system for homogenously providing process gas to openings 18 provided in the electrode plate 15. Therefore, a uniform gas distribution and thus a uniform plasma P may be generated above a surface of a substrate 19 to be coated in a PECVD coating process. In this way a uniform coating can be deposited on the substrate 19.

Due to the fact that all gas distribution elements 2, 2a, 2b, 2c, 2d, 2e, 2f, 2g, 2h have the same or a similar construction, they may be manufactured in particular machines and handled easily before being integrated in an electrode assembly according to the present invention. Another advantage of the gas distribution system 1 is that due to the composition of the elements 2, 2a, 2b, 2c, 2d, 2e, 2f, 2g, 2h (that may be formed like small cassettes or tiles) the construction of the electrode assembly according to the present invention is more stable than conventional electrode assemblies.

## Claims

1. A coating installation, particularly a PECVD coating installation, comprising:
at least a process chamber for processing a substrate (19) in said process chamber; and
at least an electrode assembly (12) arranged within said process chamber for generating and maintaining a plasma in said process chamber, wherein said electrode assembly (12) comprises an arrangement of outlet openings (7) for feeding process gas into said process chamber,
**characterized in that**
said electrode assembly (12) comprises a plurality of gas distribution elements (2a, 2b, 2c, 2d, 2e, 2f, 2g, 2h), wherein each of said gas distribution elements (2a, 2b, 2c, 2d, 2e, 2f, 2g, 2h) includes a gas distribution system.

2. The coating installation according to claim 1,
**characterized in that**
said gas distribution elements (2a, 2b, 2c, 2d, 2e, 2f, 2g, 2h) comprise an inlet opening (5) and at least an outlet opening (7), and
said gas distribution system is arranged between said inlet opening (5) and said at least one outlet opening (7) for homogenously supplying process gas fed into said inlet opening (5) to said at least one outlet opening (7).

3. The coating installation according to claim 1 or 2,
**characterized in that**
said gas distribution element (2a, 2b, 2c, 2d, 2e, 2f, 2g, 2h) is formed as a flat panel and/or a cassette and/or a tile-shaped element.

4. The coating installation according to any of the previous claims,
**characterized in that**
said electrode assembly (12) comprises a conduct system having a feed opening (8) and outlet openings to be connected to said inlet openings (5) of said gas distribution elements (2a, 2b, 2c, 2d, 2e, 2f, 2g, 2h), and at least a branch-off (9, 10) arranged between said feed opening (8) and said outlet openings of said conduct system.

5. The coating installation according to claim 4,
**characterized in that**
the flow resistance of the paths between said feed opening (8) and said outlet ports of said conduct system is substantially the same.

6. The coating installation according to any of the previous claims 4 or 5,
**characterized in that**
said conduct system comprises at least one pressure stage arranged in a path between said feed opening (8) and said outlet ports of said conduct system.

7. The coating installation according to any of the previous claims,
**characterized in that**
said gas distribution element (2a, 2b, 2c, 2d, 2e, 2f, 2g, 2h) comprises at least a gas distribution space between said inlet opening and said outlet openings (7) such that there is substantially the same pressure at said outlet openings (7).

8. The coating installation according to any of the previous claims,
**characterized in that**
said electrode assembly (12) comprises a frame (3) for supporting said gas distribution elements (2a, 2b, 2c, 2d, 2e, 2f, 2g, 2h) at said electrode assembly (12).

9. The coating installation according to claim 8,
**characterized in that**
said frame (3) comprises gas openings (11) arranged near the edge of said gas distribution system (1) for supplying process gas into said process chamber and/or for removing process gas from said process chamber.

10. The coating installation according to any of the previous claims,
**characterized in that**
said electrode assembly (12) comprises at least an electrode plate (18).

11. The coating installation according to claim 10,
**characterized in that**
said electrode plate (15) is arranged on top of said gas distribution elements (2a, 2b, 2c, 2d, 2e, 2f, 2g, 2h), and said electrode plate (15) faces a plasma generation and maintenance zone (P).

12. A method of producing an electrode assembly (12) for a PECVD coating installation, comprising the steps of:
i. providing a frame (3);
ii. providing a plurality of gas distribution elements (2a, 2b, 2c, 2d, 2e, 2f, 2g, 2h), said gas distribution elements (2a, 2b, 2c, 2d, 2e, 2f, 2g, 2h) comprising at least an inlet opening (5) and at least an outlet opening (7); and
iii. arranging and fixing said plurality of gas distribution elements (2a, 2b, 2c, 2d, 2e, 2f, 2g, 2h) to said frame (3).

13. The method according to claim 12,
**characterized in that**
said method further comprises the step of providing a gas conduct system for feeding process gas from a feed opening (8) into said inlet openings (5) of said gas distribution elements (2a, 2b, 2c, 2d, 2e, 2f, 2g, 2h).

14. The method according to claim 12 or 13,
**characterized in that**
said method further comprises the step of providing a plurality of outlet openings in said gas distribution elements (2a, 2b, 2c, 2d, 2e, 2f, 2g, 2h).

## Amended claims

### Amended claims in accordance with Rule 137(2) EPC.

**1.** A coating installation, particularly a PECVD coating installation, comprising:
at least a process chamber for processing a substrate (19) in said process chamber; and
at least an electrode assembly (12) arranged within said process chamber for generating and maintaining a plasma in said process chamber, wherein said electrode assembly (12) comprises an arrangement of outlet openings (7) for feeding process gas into said process chamber,
**characterized in that**
said electrode assembly (12) comprises a plurality of gas distribution elements (2a, 2b, 2c, 2d, 2e, 2f, 2g, 2h), wherein
each of said gas distribution elements (2a, 2b, 2c, 2d, 2e, 2f, 2g, 2h) includes a gas distribution system, and
said gas distribution elements (2a, 2b, 2c, 2d, 2e, 2f, 2g, 2h) are formed as flat panels and/or cassettes and/or tile-shaped elements.

**2.** The coating installation according to claim 1,
**characterized in that**
said gas distribution elements (2a, 2b, 2c, 2d, 2e, 2f, 2g, 2h) comprise an inlet opening (5) and at least an outlet opening (7), and
said gas distribution system is arranged between said inlet opening (5) and said at least one outlet opening (7) for homogenously supplying process gas fed into said inlet opening (5) to said at least one outlet opening (7).

**3.** The coating installation according to any of the previous claims,
**characterized in that**
said electrode assembly (12) comprises a conduct system having a feed opening (8) and outlet openings to be connected to said inlet openings (5) of said gas distribution elements (2a, 2b, 2c, 2d, 2e, 2f, 2g, 2h), and at least a branch-off (9, 10) arranged between said feed opening (8) and said outlet openings of said conduct system.

**4.** The coating installation according to claim 3,
**characterized in that**
the flow resistance of the paths between said feed opening (8) and said outlet ports of said conduct system is substantially the same.

**5.** The coating installation according to any of the previous claims 3 or 4,
**characterized in that**
said conduct system comprises at least one pressure stage arranged in a path between said feed opening (8) and said outlet ports of said conduct system.

**6.** The coating installation according to any of the previous claims,
**characterized in that**
said gas distribution element (2a, 2b, 2c, 2d, 2e, 2f, 2g, 2h) comprises at least a gas distribution space between said inlet opening and said outlet openings (7) such that there is substantially the same pressure at said outlet openings (7).

**7.** The coating installation according to any of the previous claims,
**characterized in that**
said electrode assembly (12) comprises a frame (3) for supporting said gas distribution elements (2a, 2b, 2c, 2d, 2e, 2f, 2g, 2h) at said electrode assembly (12).

**8.** The coating installation according to claim 7,
**characterized in that**
said frame (3) comprises gas openings (11) arranged near the edge of said gas distribution system (1) for supplying process gas into said process chamber and/or for removing process gas from said process chamber.

**9.** The coating installation according to any of the previous claims,
**characterized in that**
said electrode assembly (12) comprises at least an electrode plate (18).

**10.** The coating installation according to claim 9,
**characterized in that**
said electrode plate (15) is arranged on top of said gas distribution elements (2a, 2b, 2c, 2d, 2e, 2f, 2g, 2h), and said electrode plate (15) faces a plasma generation and maintenance zone (P).

**11.** A method of producing an electrode assembly (12) for a PECVD coating installation, comprising the steps of:
a. providing a frame (3);
b. providing a plurality of gas distribution elements (2a, 2b, 2c, 2d, 2e, 2f, 2g, 2h) formed as flat panels and/or cassettes and/or tile-shaped elements, said gas distribution elements (2a, 2b, 2c, 2d, 2e, 2f, 2g, 2h) comprising at least an inlet opening (5) and at least an outlet opening (7); and
c. arranging and fixing said plurality of gas distribution elements (2a, 2b, 2c, 2d, 2e, 2f, 2g, 2h) to said frame (3).

**12.** The method according to claim 11,
**characterized in that**
said method further comprises the step of providing a gas conduct system for feeding process gas from a feed opening (8) into said inlet openings (5) of said gas distribution elements (2a, 2b, 2c, 2d, 2e, 2f, 2g, 2h).

**13.** The method according to claim 11 or 12,
**characterized in that**
said method further comprises the step of providing a plurality of outlet openings in said gas distribution elements (2a, 2b, 2c, 2d, 2e, 2f, 2g, 2h).
